(19) Europäisches Patentamt
European Patent Office
Office européen des brevets

(11) **EP 4 016 790 B1**

(12) **EUROPEAN PATENT SPECIFICATION**

(45) Date of publication and mention of the grant of the patent:
**04.01.2023 Bulletin 2023/01**

(21) Application number: **21214011.5**

(22) Date of filing: **13.12.2021**

(51) International Patent Classification (IPC):
*H02J 7/00* *(2006.01)*

(52) Cooperative Patent Classification (CPC):
**H02J 7/0048; H02J 7/005;** H02J 7/007194

(54) **BATTERY CONTROL APPARATUS**

BATTERIESTEUERVORRICHTUNG

APPAREIL DE COMMANDE DE BATTERIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.12.2020 JP 2020211479**

(43) Date of publication of application:
**22.06.2022 Bulletin 2022/25**

(73) Proprietor: **Yazaki Corporation**
**Minato-ku**
**Tokyo 108-8333 (JP)**

(72) Inventors:
• **WANG, Jian**
**Shizuoka, 410-1194 (JP)**
• **FUJII, Hironao**
**Shizuoka, 410-1194 (JP)**

(74) Representative: **Hoffmann Eitle**
**Patent- und Rechtsanwälte PartmbB**
**Arabellastraße 30**
**81925 München (DE)**

(56) References cited:
**CN-A- 105 548 898** **JP-A- 2013 074 706**
**US-A1- 2014 088 898** **US-A1- 2015 293 183**

• **LAZREG MERIEM BEN ET AL: "Lithium-ion battery pack modeling using accurate OCV model: Application for SoC and SoH estimation", 2020 IEEE 4TH INTERNATIONAL CONFERENCE ON INTELLIGENT ENERGY AND POWER SYSTEMS (IEPS), IEEE, 7 September 2020 (2020-09-07), pages 175-179, XP033898147, DOI: 10.1109/IEPS51250.2020.9263207 [retrieved on 2020-11-17]**

EP 4 016 790 B1

**Description**

FIELD

The present disclosure relates to a battery control apparatus.

BACKGROUND

As a control apparatus for an in-vehicle battery, a control apparatus is known in which by setting a target upper limit value of a remaining capacity of a battery at the time of traveling during traveling of a vehicle and setting a target upper limit value of a remaining capacity of the battery at the time of parking during parking of the vehicle, the remaining capacity of the battery can be controlled to fall within a range in which progress of deterioration can be prevented, and the capacity of the battery can be used in a large range so as to sufficiently secure traveling performance of the vehicle during traveling of the vehicle (for example, refer to Patent Literature 1). In the control apparatus described in Patent Literature 1, the target upper limit value of the remaining capacity of the battery is set according to a parking time of the vehicle.

CN 105 548 898 A relates to a method for estimating SOC of a lithium battery with offline data segmentation correction to achieve accurate estimation of the SOC. The SOH value is determined using the internal resistance of the battery in order to determine the actual available capacity CN. When the battery is in a working condition, the ampere-time integration method is used to the find the SOC. Using the function relationship between an open circuit voltage and the SOC, the real value of the SOC at this time is found, wherein this value is used as the initial value of SOC for the ampere-time integration method. The ampere-time integration method is used to continue estimating the SOC value.

US 2015/293183 A1 relates to a SOC estimation method for estimating the SOC of the battery. A SOC-OCV table is described for showing the relationship between the SOC of the battery cells and the open circuit voltage (OCV) of the battery cells, wherein the SOC is identified corresponding to the OCV. A SOH estimation unit estimates the SOH of the battery cells on the basis of a variation value of the SOC and an integrated current value in the time period required for the variation. The SOH estimation processing is executed in parallel with the SOC estimation processing by a current integration method.

US 2014/088898 A1 relates to a technology of estimating a SOH for an ESS and compensating for battery capacity therethrough. A SOC compensation processor multiplies initial rated capacity by the SOH, thereby calculating an SOC compensation capacity.

JP 2013 074706 A relates to a control device to maintain and improve the durability by suppressing deterioration of a battery.

Patent Literature 1: JP-A-2013-074706

SUMMARY

In the control apparatus described in Patent Literature 1, when the parking time of the vehicle is within one day, the target upper limit value of the remaining capacity of the battery is set to 70% of a full charge amount of the battery, and when the parking time of the vehicle is two days or more and less than three days, the target upper limit value of the remaining capacity of the battery is set to 50% to 60% of the full charge amount of the battery. That is, the target upper limit value of the remaining capacity of the battery is set to be lower as the parking time of the vehicle is longer. However, in a case of a lithium ion battery, since a rated capacity decreases with deterioration, it is necessary to set a charge rate to be high according to the deterioration in order to guarantee the same output.

In view of the above circumstances, an object of the present disclosure is to provide a battery control apparatus capable of preventing deterioration of a battery and securing required output of the battery.

The present invention is defined in the appended independent claim. Further preferred embodiments are defined in the dependent claim.

The present disclosure provides a battery control apparatus including: a controller configured to control charging and discharging of a battery, wherein during a use period of the battery, the controller is configured to: estimate a state of health of the battery to obtain an estimated state of health; obtain, in accordance with relationship information indicating a relationship between a state of health of the battery after deterioration and a state of charge of the battery after deterioration, a state of charge after deterioration corresponding to the estimated state of health; and adjust the state of charge of the battery to the state of charge after deterioration.

According to the present disclosure, by setting an SOC of a battery according to an SOH, it is possible to prevent deterioration of the battery and to secure required output of the battery.

BRIEF DESCRIPTION OF DRAWINGS

Fig. 1 is a diagram showing an outline of a battery control apparatus according to an embodiment of the present disclosure.
Fig. 2 is a diagram showing an outline of a battery control apparatus according to another embodiment of the present disclosure.
Fig. 3 is a diagram showing an outline of a deterioration coefficient table of the battery control apparatus shown in Fig. 2.
Fig. 4 is a flowchart showing processing performed by an MCU shown in Fig. 2.

## DETAILED DESCRIPTION

Hereinafter, the present disclosure will be described in accordance with a preferred embodiment. The present disclosure is not limited to the embodiment to be described below, and can be changed as appropriate without departing from the scope of the present disclosure. Although some configurations are not illustrated or described in the embodiment to be described below, a known or well-known technique is appropriately applied to details of an omitted technique within a range in which no contradiction occurs to contents to be described below.

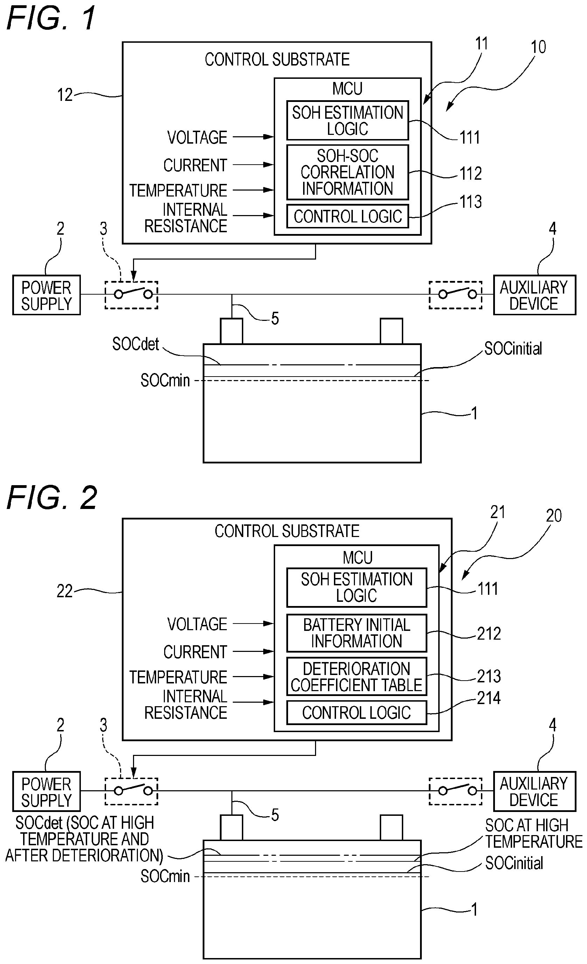

Fig. 1 is a diagram showing an outline of a battery control apparatus 10 according to an embodiment of the present disclosure. As shown in this drawing, the battery control apparatus 10 is a control apparatus that controls charging and discharging of an in-vehicle battery 1, and particularly adjusts an SOC (State Of Charge indicating charge rate or charge state) of the battery 1 during storage.

A vehicle on which the battery control apparatus 10 is mounted is a hybrid vehicle or an electric vehicle. The battery 1 is provided as a sub power supply, and the high-voltage power supply 2 is provided as a main power supply that supplies electric power to a motor. The battery 1 of the present embodiment is a lithium ion battery containing manganese as a positive electrode active material, and supplies electric power to an in-vehicle auxiliary device (electrical component) 4. The auxiliary device 4 is an example of a load.

The power supply 2 and the battery 1 are connected by a power line 5. The power line 5 is provided with a switch 3, a DC/DC converter (not shown), and the like. When the switch 3 is turned on/off by the battery control apparatus 10, a charge time of the battery 1 is adjusted, and the SOC of the battery 1 is adjusted.

The battery control apparatus 10 includes a control substrate 12 on which a micro controller unit (MCU) 11 is mounted. The MCU 11 is an example of a controller. The MCU 11 stores an SOH estimation logic 111 that estimates the State of Health (SOH) of the battery 1, SOH-SOC correlation information 112 that is information on a correlation between the SOH of the battery 1 and the SOC during storage (after deterioration) of the battery 1, and a control logic 113 that controls the charging and discharging of the battery 1. The SOH-SOC correlation information 112 is an example of correlation information. Information such as an open circuit voltage of the battery 1, an output voltage, an output current, an internal resistance of the battery 1, and an environmental temperature at which the battery 1 is stored is input to the MCU 11. The internal resistance of the battery 1 may be calculated by the MCU 11. The MCU 11 may include a processor and a memory storing instructions that, when executed by the processor, cause the processor to perform operations by at least one of the SOH estimation logic 111, the SOH-OSC correlation information 112 and the control logic 113. The SOH-SOC correlation information 112 may be stored in the memory or may be stored in another storage.

The SOH estimation logic 111 of the MCU 11 estimates (calculates) the SOH of the battery 1 based on the open circuit voltage of the battery 1, the output voltage, the output current, the internal resistance of the battery 1, and the like. As a method of estimating the SOH, various known methods of estimating the SOH by using a temporal change of the SOC or/and a temporal increase of the internal resistance may be used. Examples of the method of estimating the SOH include a method based on a charge and discharge test, a method based on a current integration method, a method based on measurement of an open circuit voltage, a method based on measurement of a terminal voltage, a method based on a model (the above is a method using the temporal change of the SOC), a method based on alternating current impedance measurement, a method using an adaptive digital filter based on a model, a method based on linear regression (a slope of a straight line of I-V characteristics) from I-V characteristics (current-voltage characteristics), a method based on a step response (a method of estimating by using the temporal increase of the internal resistance), and the like.

The SOH-SOC correlation information 112 includes an SOCinitial which is the SOC of the battery 1 in an initial state (that is, the SOH is 100%). The SOCinitial is calculated by the following Equation (1).

$$\mathrm{SOCinitial = SOCmin + Derror} \ ... \ (1)$$

The SOCmin is a lower limit value of the SOC and is calculated by the following Equation (2). The Derror is a detection error.

$$\mathrm{SOCmin = Cneed/Cfull} \ ... \ (2)$$

The Cneed is a charge capacity required to satisfy required output of the battery 1 according to a specification of the auxiliary device 4 which is a power supply destination, and the Cfull is an initial full charge capacity of the battery 1. The Cneed is an example of a predetermined charge capacity.

Further, the SOH-SOC correlation information 112 includes an SOCdet (an example of an SOC after deterioration) which is the SOC of the battery 1 during a use period (that is, the SOH is less than 100%). The SOCdet is calculated by the following Equation (3).

$$\mathrm{SOCdet = Cneed/(Cfull - Cdet)} \ ... \ (3)$$

The Cdet is an amount of decrease in the charge capacity due to the deterioration, and is calculated by the following Equation (4). The Cfull - Cdet corresponds to a full charge capacity of the battery 1 after the deterioration.

$$\mathrm{Cdet} = (1 - \mathrm{SOH}) \times \mathrm{Cfull} \ ... \ (4)$$

The SOH estimation logic 111 of the MCU 11 estimates the SOH of the battery 1 periodically (for example, every month) during the use period of the battery 1, and the control logic 113 of the MCU 11 calculates the SOCdet corresponding to the SOH estimated by the SOH estimation logic 111 by the above Equation (3). Then, the control logic 113 adjusts the charge time of the battery 1 by the switch 3 such that the SOC of the battery 1 is the SOCdet.

That is, in the battery control apparatus 10 of the present embodiment, the SOCinitial, which is an initial value of the SOC of the battery 1, is set to a value obtained by adding the detection error Derror to the SOCmin, which is the minimum required in relation to the auxiliary machine 4 as the power supply destination. Accordingly, the SOC of the battery 1 in the initial state is suppressed to a necessary minimum, and therefore, the deterioration of the battery 1 can be prevented, and the required output of the battery 1 required in relation to the auxiliary device 4 as the power supply destination can be secured.

Further, in the battery control apparatus 10 of the present embodiment, the SOCdet of the battery 1 during the use period is set to a value obtained by dividing the charge capacity Cneed required in relation to the auxiliary machine 4 as the power supply destination by the full charge capacity after the deterioration (a value obtained by subtracting the deterioration amount Cdet of the charge capacity from the initial full charge capacity Cfull). Accordingly, the SOC of the battery 1 during the use period is suppressed to the necessary minimum, and therefore, the deterioration of the battery 1 is prevented, and the SOC of the battery 1 during the use period is periodically increased to the SOCdet corresponding to the deterioration of the battery 1, and therefore, the required output of the battery 1 required in relation to the auxiliary machine 4 as the power supply destination can be secured.

Fig. 2 is a diagram showing an outline of a battery control apparatus 20 according to another embodiment of the present disclosure. The same reference numerals are given to configurations similar to those of the above-described embodiment, and the description of the above-described embodiments is incorporated. As shown in Fig. 2, the battery control apparatus 20 includes a control substrate 22 on which an MCU 21 is mounted. The MCU 21 is an example of a controller. The MCU 21 stores the SOH estimation logic 111, battery initial information 212 which is information of the battery 1 in an initial state, a deterioration coefficient table 213, and a control logic 214. The deterioration coefficient table 213 is an example of correlation information. Further, information such as an open circuit voltage of the battery 1, an output voltage, an output current, an internal resistance of the battery 1, and an environmental temperature at which the battery 1 is stored is input to the MCU 21. The internal resistance of the battery 1 may be calculated by the MCU 21. The MCU 21 may include a processor and a memory storing instructions that, when executed by the processor, cause the processor to perform operations by at least one of the SOH estimation logic 111, the battery initial information 212, the deterioration coefficient table 213 and the control logic 214. At least one of the battery initial information 212 and the deterioration coefficient table 213 may be stored in the memory or may be stored in another storage.

The SOH estimation logic 111 has a function similar to that of the above-described embodiment. Further, the battery initial information 212 includes an SOCinitial which is the SOC of the battery 1 in an initial state (that is, the SOH is 100%). The SOCinitial is calculated by the above Equation (1).

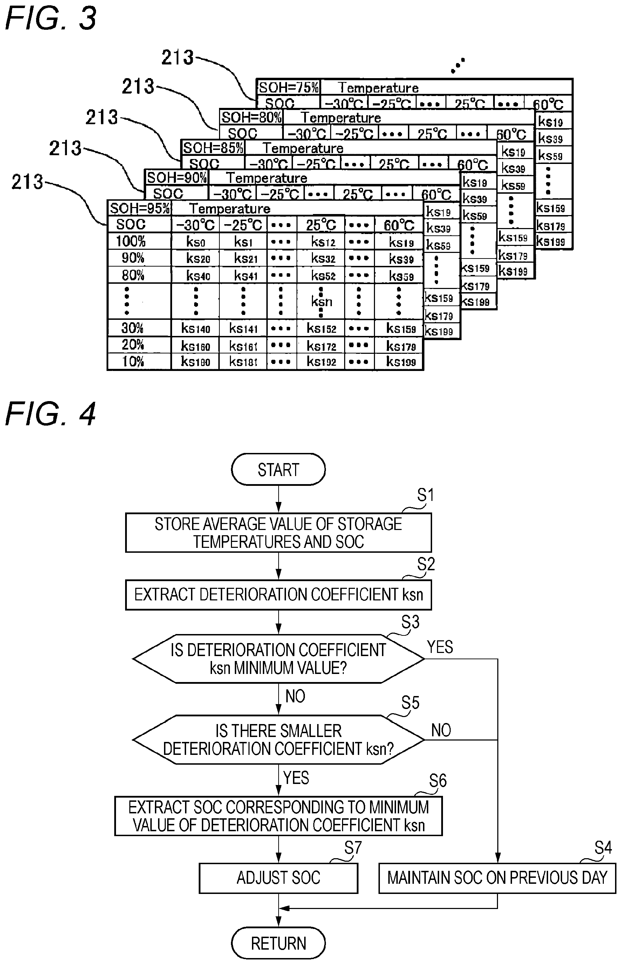

The deterioration coefficient table 213 is a table indicating information on a correlation among the SOH of the battery 1, the SOC during storage (after deterioration) of the battery 1, a temperature during storage of the battery 1 (hereinafter referred to as a storage temperature), and a deterioration coefficient ksn of the battery 1 (see Fig. 3). The details will be described later. The control logic 214 sets the SOC of the battery 1 in the initial state (SOH = 100%) to the SOCinitial, and after the second day from the start of use, periodically (for example, every day) adjusts the SOC of the battery 1 during the use period based on the SOH of the battery 1 estimated by the SOH estimation logic 111, an average value of the obtained storage temperatures, and the deterioration coefficient table 213.

Here, as described in the papers described later, even when the deterioration of the battery 1 does not progress, the progress of the deterioration is fast at the SOC = 100% at 25°C, but the progress of the deterioration is fast at the SOC = 60% and 70% at 60°C. Therefore, in the present embodiment, even when the deterioration of the battery 1 does not progress, when the environmental temperature increases, the progress of the deterioration of the battery 1 is prevented by increasing the SOC of the battery 1 from the SOCinitial (for example, 60%) to an SOC (for example, 80%) at a high temperature in the drawing.

Fig. 3 is a diagram showing an outline of the deterioration coefficient table 213 of the battery control apparatus 20 shown in Fig. 2. As shown in this drawing, the deterioration coefficient table 213 is a table indicating a relationship among the SOC, the storage temperature, and the deterioration coefficient ksn at a predetermined SOH. The predetermined SOH is set every 5%, for example, 95%, 90%, 85%, and so on. That is, a plurality of deterioration coefficient tables 213 are stored in the MCU 21. In each deterioration coefficient table 213, the SOC is set for every 10%, for example, 100%, 90%, 80%, and so on, and the storage temperature is set for every 5°C, for example, - 30°C, ..., - 5°C, 0°C, 5°C, and so on. The deterioration coefficient ksn (ks0, ks1, ks2, ..., ksn, n is an integer of 0 or more) is set for each corresponding SOC and storage temperature, for example, ks0 when the SOC = 100% and the storage temperature is - 30°C, ks32 when the SOC = 90% and the storage temperature is 25°C.

The deterioration coefficient ksn is set based on a result of a storage test of the battery 1. A larger value of the deterioration coefficient ksn indicates larger deterioration, and a smaller value of the deterioration coefficient ksn indicates smaller deterioration. Here, storage deterioration of a lithium ion battery does not always progress easily as the SOC and the storage temperature during storage are higher, and depending on a battery material, recent studies have shown that the storage deterioration of the lithium ion battery easily progresses when the battery is stored at a specific SOC and a specific storage temperature (JARI Research Journal 20151201, "Calendar Degradation Mechanism of Lithium-ion Batteries with a LiMn2O4 and LiMO2 (M = Co, Ni and Mn) Composite Cathode", Authors: Keisuke ANDO, Tomoyuki MATSUDA, Masao MYOJIN, Daichi IMAMURA). In particular, in a case where manganese is contained in a positive electrode active material, it has been found that when the storage temperature is 25°C, the SOC is 100% and the progress of the deterioration is maximum, but when the storage temperature is 60°C, the SOC is 60% and 70% and the progress of the deterioration is maximum. Further, it has also been found that, in the case where the storage temperature is 60°C, the SOC is 70% and the progress of the deterioration is maximum during a period from the start of use to 150 days, and the SOC is 60% and the progress of the deterioration is maximum after 150 days from the start of use.

That is, it has been found that, in a specific lithium ion battery in which manganese is contained in a positive electrode active material and the like, the progress of specific deterioration is remarkable at a specific SOC lower than 100% at a specific storage temperature, and the progress of the specific deterioration exceeds the progress of the deterioration when the SOC is 100%.

Therefore, in the deterioration coefficient table 213 of the present embodiment, the deterioration coefficient ksn increases as the SOC and the storage temperature during storage increase, but the deterioration coefficient ksn corresponding to the specific storage temperature and the specific SOC of less than 100% is set to a value larger than the deterioration coefficient ksn corresponding to the specific storage temperature and SOC = 100%. For example, in the deterioration coefficient table 213 of a specific SOH (corresponding to an SOH from the start of use to the 150th day), the deterioration coefficient ksn corresponding to the storage temperature = 60°C and the SOC = 70% is set to a maximum value among the deterioration coefficients ksn corresponding to the storage temperature = 60°C. Alternatively, in the deterioration coefficient table 213 of a specific SOH (corresponding to an SOH after the 150th day from the start of use), the deterioration coefficient ksn corresponding to the storage temperature = 60°C and the SOC = 60% is set to the maximum value among the deterioration coefficients ksn corresponding to the storage temperature = 60°C.

Fig. 4 is a flowchart showing processing performed by the MCU 21 shown in Fig. 2. First, the control logic 214 of the MCU 21 sets the initial value of the SOC of the new battery 1 to the SOCinitial, and starts the processing. Here, the SOCinitial is derived from a table in which the SOH = 100% and the storage temperature is 25°C. In step S1, the control logic 214 calculates an average value of the storage temperature (environmental temperature) for one day from the use start date of the new battery 1, and stores the average value in a memory (not shown) in association with the SOC. Next, in step S2, the control logic 214 reads, from the memory, the average value of the storage temperature for one day on the previous day and the SOC on the previous day after the second day from the start of use of the new battery 1, causes the SOH estimation logic 111 to estimate the present SOH of the battery 1, and extracts, from the deterioration coefficient table 213, the deterioration coefficient ksn corresponding to the average value of the storage temperature for one day on the previous day and the SOC on the previous day by referring to the deterioration coefficient table 213 corresponding to the estimated SOH. For example, when the SOH on the day is 90%, the average value of the storage temperature on the previous day is 25°C, and the SOC during storage on the previous day is 80%, the deterioration coefficient ksn corresponding to the SOC = 80% and the storage temperature = 25°C is extracted from the deterioration coefficient table 213 of the SOH = 90%.

Next, in step S3, the control logic 214 determines whether the deterioration coefficient ksn extracted in step S2 is a minimum value among a plurality of deterioration coefficients corresponding to the storage temperature on the previous day in the deterioration coefficient table 213 selected in step S2. When an affirmative determination is made in step S3, the processing proceeds to step S4, and when a negative determination is made in step S3, the processing proceeds to step S5.

In step S4, the control logic 214 maintains the SOC of the battery 1 at the SOC on the previous day. On the other hand, in step S5, the control logic 214 determines whether there is a deterioration coefficient ksn smaller than the deterioration coefficient ksn extracted in step S2 among the plurality of deterioration coefficients ksn corresponding to the storage temperature on the previous day and the SOC equal to or larger than the SOCmin in the deterioration coefficient table 213 selected in step S2. When an affirmative determination is made in step S5, the processing proceeds to step S6, and when a negative determination is made in step S5, the processing proceeds to step S4.

In step S6, the control logic 214 extracts a deterioration coefficient ksn having a value smaller than the deterioration coefficient ksn extracted in step S2, and extracts the SOC corresponding to the deterioration coefficient ksn from the deterioration coefficient table 213. Next, in step S7, the control logic 214 sets the SOC of the battery 1 to the SOC (SOCdet) extracted in step S6. The above processing (steps S1 to S7) is repeatedly executed.

As described above, in the battery control apparatus 20 of the present embodiment, the MCU 21 obtains the SOC (SOCdet) after the deterioration based on the deterioration coefficient table 213 indicating the relationship between the predetermined SOH of the battery 1 after the deterioration, the SOC, the storage temperature, and the deterioration coefficient ksn, and adjusts the SOC of the battery 1 to the SOCdet. Specifically, the MCU 21 estimates the SOH of the battery 1 and obtains the storage temperature of the battery 1 during the use period of the battery 1, obtains one or the plurality of deterioration coefficients ksn corresponding to the estimated SOH, the obtained storage temperature, and the SOC equal to or larger than the SOCmin from the deterioration coefficient table 213, and obtains, as the SOCdet, the SOC corresponding to a minimum deterioration coefficient ksn among the obtained one or the plurality of deterioration coefficients ksn. That is, the battery control apparatus 20 of the present embodiment sets the SOC (SOCdet) of the battery 1 during storage such that the deterioration coefficient ksn is as small as possible according to the SOH (use period) and the environmental temperature. Accordingly, the deterioration of the battery 1 can be effectively prevented, and the required output of the battery 1 can be secured.

In particular, in the deterioration coefficient table 213 of the present embodiment, the deterioration coefficient ksn corresponding to a predetermined storage temperature (for example, 60°C) and a predetermined SOC (for example, 60% or 70%) is set to a value larger than the deterioration coefficient ksn corresponding to the predetermined storage temperature and an SOC (for example, 100%) larger than the predetermined SOC. Accordingly, by setting the SOC of the battery 1 so as to avoid the SOC in which the deterioration specifically progresses with respect to the battery 1 in which the deterioration specifically progresses in the case of the predetermined storage temperature and the predetermined SOC, the deterioration of the battery 1 can be effectively prevented, and the life can be extended.

Although the storage temperature is the environmental temperature and an average temperature on the previous day, other measurement values such as the temperature of the battery 1 itself and a median value of the environmental temperature on the previous day may be used as the storage temperature. Further, in the above embodiment, the initial SOC of the battery 1 is set to the SOCinitial less than 100%, but the initial SOC of the battery 1 may be set to 100%.

Further, in the above embodiment, the present disclosure has been described by taking the battery 1 that supplies electric power to the in-vehicle auxiliary device 4 as an example, and the battery of the present disclosure can also be applied to a power battery pack or a 12 V main battery. Further, in the above embodiment, the present disclosure has been described by taking the battery 1, which is a lithium ion battery containing manganese as a positive electrode active material, as an example, but manganese is an example, and the present disclosure can be applied to any battery having a specific SOC in which the progress of the specific deterioration is remarkable.

As described above, a battery control apparatus 10; 20 includes a controller 11; 21 configured to control charging and discharging of a battery 1. During a use period of the battery 1, the controller 11; 21 is configured to: estimate a state of health of the battery 1 to obtain an estimated state of health; obtain, in accordance with relationship information 112; 213 indicating a relationship between a state of health of the battery 1 after deterioration and a state of charge of the battery 1 after the deterioration, a state of charge after deterioration corresponding to the estimated state of health; and adjust the state of charge of the battery 1 to the state of charge after deterioration.

In the battery control apparatus 10, the battery 1 is configured to supply electric power to a load 4, the state of charge after deterioration is obtained by dividing a predetermined charge capacity by a full charge capacity of the battery 1 after deterioration, and the predetermined charge capacity is a charge capacity that satisfies an output of the battery 1 which is required by the load 4.

In the battery control apparatus 20, the relationship information 213 includes a table 213 indicating a relationship among the state of health of the battery 1 after the deterioration, the state of charge of the battery 1 after the deterioration, a storage temperature, and a deterioration coefficient, and during a use period of the battery 1, the controller 21 is configured to: obtain the estimated state of health of the battery 1 and obtain a storage temperature of the battery 1; obtain, from the table 213, one or more deterioration coefficients corresponding to the estimated state of health, the obtained storage temperature, and a state of charge equal to or larger than a predetermined lower limit value; and obtain, as the state of charge after the deterioration, a state of charge corresponding to a minimum deterioration coefficient of the one or more deterioration coefficients.

In the battery control apparatus 20, in the table 213, a deterioration coefficient corresponding to a predetermined storage temperature and a predetermined state of charge is set to a value larger than a deterioration coefficient corresponding to the predetermined storage temperature and a state of charge larger than the predetermined state of charge.

**Claims**

1. A battery control apparatus (20) comprising:

a controller (21) configured to control charging and discharging of a battery (1), wherein during a use period of the battery (1), the controller (21) is configured to:

estimate a state of health of the battery (1) to obtain an estimated state of health;
obtain, in accordance with relationship information (213) indicating a relationship between a state of health of the battery (1) after deterioration and a state of charge after deterioration, the state of charge after deterioration corresponding to the estimated state of health, wherein the state of charge after deterioration is a state of charge of the battery (1) during the use period; and
adjust the state of charge of the battery (1) to the state of charge after deterioration.,

**characterized in that**:

the relationship information (213) comprises a table (213) indicating a relationship among the state of health of the battery (1) after the deterioration, the state of charge after deterioration of the battery (1), a storage temperature, and a deterioration coefficient, and
during the use period of the battery (1), the controller (21) is configured to:

obtain the estimated state of health of the battery (1) and obtain a storage temperature of the battery (1);
obtain, from the table (213), one or more deterioration coefficients corresponding to the estimated state of health, the obtained storage temperature, and a state of charge equal to or larger than a predetermined lower limit value; and

obtain, as the state of charge after the deterioration, a state of charge corresponding to a minimum deterioration coefficient of the one or more deterioration coefficients.

2. The battery control apparatus (20) according to claim 1,
wherein in the table (213), a deterioration coefficient corresponding to a predetermined storage temperature and a predetermined state of charge is set to a value larger than a deterioration coefficient corresponding to the predetermined storage temperature and a state of charge larger than the predetermined state of charge.

**Patentansprüche**

1. Batteriesteuereinrichtung (20), umfassend:

eine Steuereinheit (21), die konfiguriert ist, Laden und Entladen einer Batterie (1) zu steuern, wobei die Steuereinheit (21) während einer Einsatzdauer der Batterie (1) konfiguriert ist zum:

Schätzen eines Gesundheitszustands der Batterie (1), um einen geschätzten Gesundheitszustand zu erhalten;
Erhalten, in Übereinstimmung mit Beziehungsinformationen (213), die eine Beziehung zwischen einem Gesundheitszustand der Batterie (1) nach Verschlechterung und einem Ladezustand nach Verschlechterung angeben, des Ladezustands nach Verschlechterung, der dem geschätzten Gesundheitszustand entspricht, wobei der Ladezustand nach Verschlechterung ein Ladezustand der Batterie (1) während der Einsatzdauer ist; und
Anpassen des Ladezustands der Batterie (1) an den Ladezustand nach Verschlechterung,

**dadurch gekennzeichnet, dass**:

die Beziehungsinformationen (213) eine Tabelle (213) umfassen, die eine Beziehung unter dem Gesundheitszustand der Batterie (1) nach der Verschlechterung, dem Ladezustand nach Verschlechterung der Batterie (1), einer Lagertemperatur und einem Verschlechterungskoeffizienten angeben, und
die Steuereinheit (21) während der Einsatzdauer der Batterie (1) konfiguriert ist zum:

Erhalten des geschätzten Gesundheitszustands der Batterie (1) und Erhalten einer Lagertemperatur der Batterie (1);
Erhalten, aus der Tabelle (213), eines oder mehrerer Verschlechterungskoeffizienten, die dem geschätzten Gesundheitszustand, der erhaltenen Lagertemperatur und einem Ladezustand entsprechen, der gleich oder größer ist als ein vorbestimmter unterer Grenzwert; und

Erhalten, als den Ladezustand nach der Verschlechterung, eines Ladezustands, der einem Mindestverschlechterungskoeffizienten des einen oder der mehreren Verschlechterungskoeffizienten entspricht.

2. Batteriesteuereinrichtung (20) nach Anspruch 1, wobei in der Tabelle (213) ein Verschlechterungskoeffizient, der einer vorbestimmten Lagertemperatur und einem vorbestimmten Ladezustand entspricht, auf einen Wert eingestellt wird, der größer ist als ein Verschlechterungskoeffizient, der der vorbestimmten Lagertemperatur und einem Ladezustand entspricht, der größer ist als der vorbestimmte Ladezustand.


**Revendications**

1. Appareil de commande de batterie (20) comprenant :

un dispositif de commande (21) configuré pour commander le chargement et le déchargement d'une batterie (1), dans lequel pendant une période d'utilisation de la batterie (1), le dispositif de commande (21) est configuré pour :

estimer un état de santé de la batterie (1) pour obtenir un état de santé estimé ; obtenir, conformément aux informations de relation (213) indiquant une relation entre un état de santé de la batterie (1) après détérioration et un état de charge après détérioration, l'état de charge après détérioration correspondant à l'état de santé estimé, dans lequel l'état de charge après détérioration est un état de charge de la batterie (1) pendant la période d'utilisation ; et ajuster l'état de charge de la batterie (1) à l'état de charge après détérioration,

**caractérisé en ce que** :

les informations de relation (213) comprennent un tableau (213) indiquant une relation entre l'état de santé de la batterie (1) après la détérioration, l'état de charge après détérioration de la batterie (1), une température de stockage, et un coefficient de détérioration, et pendant la période d'utilisation de la batterie (1), le dispositif de commande (21) est configuré pour :

obtenir l'état de santé de la batterie estimé (1) et obtenir une température de stockage de la batterie (1) ; obtenir, à partir du tableau (213), un ou plusieurs coefficients de détérioration correspondant à l'état de santé estimé, à la température de stockage obtenue et à un état de charge égal ou supérieur à une valeur limite inférieure prédéterminée ; et

obtenir, en tant qu'état de charge après la détérioration, un état de charge correspondant à un coefficient de détérioration minimum parmi les un ou plusieurs coefficients de détérioration.

2. Appareil de commande de batterie (20) selon la revendication 1, dans lequel dans le tableau (213), un coefficient de détérioration correspondant à une température de stockage prédéterminée et à un état de charge prédéterminé est fixé à une valeur supérieure à un coefficient de détérioration correspondant à la température de stockage prédéterminée et à un état de charge supérieur à l'état de charge prédéterminé.

## FIG. 1

## FIG. 2

## FIG. 3

| SOH=95% | Temperature | | | | | |
|---|---|---|---|---|---|---|
| SOC | -30°C | -25°C | ... | 25°C | ... | 60°C |
| 100% | ks0 | ks1 | ... | ks12 | ... | ks19 |
| 90% | ks20 | ks21 | ... | ks32 | ... | ks39 |
| 80% | ks40 | ks41 | ... | ks52 | ... | ks59 |
| ⋮ | ⋮ | ⋮ | ⋮ | ksn | ⋮ | ⋮ |
| 30% | ks140 | ks141 | ... | ks152 | ... | ks159 |
| 20% | ks160 | ks161 | ... | ks172 | ... | ks179 |
| 10% | ks180 | ks181 | ... | ks192 | ... | ks199 |

## FIG. 4

START

S1 STORE AVERAGE VALUE OF STORAGE TEMPERATURES AND SOC

S2 EXTRACT DETERIORATION COEFFICIENT ksn

S3 IS DETERIORATION COEFFICIENT ksn MINIMUM VALUE? — YES → S4 MAINTAIN SOC ON PREVIOUS DAY

NO

S5 IS THERE SMALLER DETERIORATION COEFFICIENT ksn? — NO → S4 MAINTAIN SOC ON PREVIOUS DAY

YES

S6 EXTRACT SOC CORRESPONDING TO MINIMUM VALUE OF DETERIORATION COEFFICIENT ksn

S7 ADJUST SOC

RETURN

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 105548898 A
- US 2015293183 A1
- US 2014088898 A1
- JP 2013074706 A

**Non-patent literature cited in the description**

- **KEISUKE ANDO ; TOMOYUKI MATSUDA ; MASAO MYOJIN ; DAICHI IMAMURA.** Calendar Degradation Mechanism of Lithium-ion Batteries with a LiMn2O4 and LiMO2 (M = Co, Ni and Mn) Composite Cathode. *JARI Research Journal,* 01 December 2015